(19) Europäisches Patentamt
European Patent Office
Office européen des brevets

(11) EP 3 767 394 A1

(12) EUROPEAN PATENT APPLICATION

(43) Date of publication:
20.01.2021 Bulletin 2021/03

(51) Int Cl.:
G03F 9/00 (2006.01)   G03F 7/20 (2006.01)

(21) Application number: 19186925.4

(22) Date of filing: 18.07.2019

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(71) Applicant: ASML Netherlands B.V.
5500 AH Veldhoven (NL)

(72) Inventors:
• DAI, Jin
5500 AH Veldhoven (NL)
• LALBAHADOERSING, Sanjaysingh
5500 AH Veldhoven (NL)

(74) Representative: ASML Netherlands B.V.
Corporate Intellectual Property
P.O. Box 324
5500 AH Veldhoven (NL)

(54) MARK, OVERLAY TARGET, AND METHODS OF ALIGNMENT AND OVERLAY

(57) A resonant amplitude grating mark has a periodic structure configured to scatter radiation 602 of wavelength $\lambda$ incident 600 on the alignment mark. The scattering is mainly by coupling of the incident radiation to a waveguiding mode in the periodic structure. The effective refractive indexes ($n_1$, $n_2$) and lengths ($d_1$, $d_2$) of portions of the periodic structure are configured to provide an optical path length of the unit cell in the direction of periodicity ($n_1d_1 + n_2d_2$) that equals an integer multiple of a wavelength present in the spectrum of the radiation ($m\lambda$). The effective refractive indexes ($n_1$, $n_2$) and lengths ($d_1$, $d_2$) of the portions are also configured to provide an optical path length of the second portion in the direction of periodicity ($n_2d_2$) that is from 0.30 to 0.49 of the wavelength present in the spectrum of the radiation.

Fig. 6

**Description**

FIELD

The present disclosure relates to a mark, an overlay target, and associated methods of alignment and determining an overlay error usable, for example, in the manufacture of devices by lithographic techniques.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-kl lithography may be used to process features with dimensions smaller than the classical resolution limit of a lithographic apparatus. In such process, the resolution formula may be expressed as $CD = k1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

The accurate placement of patterns on the substrate is a chief challenge for reducing the size of circuit components and other products that may be produced by lithography. In particular, the challenge of measuring accurately the features on a substrate which have already been laid down is a critical step in being able to align successive layers of features in superposition accurately enough to produce working devices with a high yield. So-called overlay should, in general, be achieved within a few tens of nanometers in today's sub-micron semiconductor devices, down to a few nanometers in the most critical layers.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of electromagnetic radiation onto a target and measure one or more properties of the scattered electromagnetic radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

Conventional binary phase grating marks rely on the interference between the diffracted light from the top of the lines and bottom of the spaces. The diffraction of light is highly dependent on the grating depth. The interference between + and - diffraction orders are detected by an alignment sensor to determine the alignment position. For an ideal mark without any asymmetries, the Alignment Position Deviation (APD) should theoretically be 0. However, due to the imperfections in processes, e.g. etching, chemical-mechanical polishing (CMP), deposition, etc., the mark can be deformed in many different ways. Typical mark deformation can be simplified and categorized in three main asymmetry types, including Floor Tilt (FT), Side Wall Angle (SWA), and Top Tilt (TT). The mark depth can also be different from nominal values due to process. When one or many of these asymmetries appears in the printed mark it will lead to an alignment error, i.e., APD. Due to the interference nature of a phase grating, the impacts of asymmetries on APD also depends strongly on the mark depth.

Overlay targets that are used to measure overlay error also suffer from the same problems of deformation. This can lead to inaccuracies in the measured overlay error.

International patent publication number WO2019081091A1, which is incorporated herein by reference in its entirety, described these problems and disclosed a solution comprising resonant amplitude mark. A mark is formed on a planar substrate, the mark comprising a periodic structure configured to scatter radiation incident on a surface plane of the alignment mark, the surface plane parallel to the substrate's plane, the scattering mainly by excitation of a resonant mode in the periodic structure parallel to the surface plane. A problem with that approach it that it is restricted to design rules based on resonance.

SUMMARY

It is desirable to have marks and overlay targets that are less sensitive to mark asymmetry rising from process-induced deformation over a wide design-rule margin.

According to a first aspect of the present invention, there is provided a mark formed on a planar substrate, the mark comprising a periodic structure configured to scatter radiation incident on the alignment mark, the scattering mainly by coupling of the incident radiation to a waveguiding mode in the periodic structure, wherein the periodic structure has a repeated unit cell divided into adjacent first and second portions along a direction of periodicity,

- the first portion having a first effective refractive index and a first length along the direction of periodicity,
- the second portion having a second effective refractive index, which is lower over its optical path compared to the first effective refractive index, and a second length along the direction of periodicity,

wherein the effective refractive indexes and lengths of the portions are configured to provide:

- an optical path length of the unit cell in the direction of periodicity that equals an integer multiple of a wavelength present in the spectrum of the radiation and
- an optical path length of the second portion in the direction of periodicity that is from 0.30 to 0.49 of the wavelength present in the spectrum of the radiation.

According to a second aspect of the present invention, there is provided a substrate comprising the mark in accordance with the first aspect.

According to a third aspect of the present invention, there is provided an overlay target comprising a lower mark in accordance with the first aspect, overlaid with an upper mark having a pitch the same as the lower mark and comprising a periodic structure configured to scatter radiation without scattering mainly by coupling of the incident radiation to a waveguiding mode in its periodic structure.

According to a fourth aspect of the present invention, there is provided a substrate comprising the overlay target of the third aspect.

According to a fifth aspect of the present invention, there is provided a method of alignment comprising the steps:

- providing an alignment mark formed on a planar substrate, in accordance with the mark of the first aspect;
- illuminating the alignment mark with radiation;
- detecting the radiation scattered by the alignment mark arising from the illumination; and
- determining a position of the alignment mark using the detected radiation.

According to a seventh aspect of the present invention, there is provided a method of determining an overlay error comprising the steps:

- providing an overlay target formed on a planar substrate, the overlay target comprising a lower mark overlaid with an upper mark having a pitch the same as the lower mark, wherein:

  - the lower mark comprises a mark in accordance with the first aspect; and
  - the upper mark comprises a periodic structure configured to scatter radiation without scattering mainly by coupling of the incident radiation to a waveguiding mode in its periodic structure;

- illuminating the overlay target with radiation;
- detecting radiation scattered by the overlay target arising from the illumination; and
- determining an overlay error between the upper and lower marks using the detected radiation.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts diffraction by a conventional phase grating;
- Figure 3 depicts diffraction by an amplitude grating;
- Figure 4 depicts a grating in the resonance regime;
- Figure 5 depicts a resonant amplitude mark (RAM);
- Figure 6 depicts a guided mode mark (GMM), in accordance with an embodiment of the present invention;
- Figure 7 depicts field distributions for a single trench for each of four different critical dimensions;
- Figure 8 depicts Wafer Quality (WQ) and Alignment Position Deviation (APD) as a function of alignment mark depth in the presence of 1nm Floor Tilt asymmetry for each of the four different critical dimensions shown in Figure 7;
- Figure 9 is a flowchart of a method of alignment in accordance with an embodiment of the present invention; and
- Figure 10 is a flowchart of a method of overlay error measurement in accordance with an embodiment of the present invention.

## DETAILED DESCRIPTION

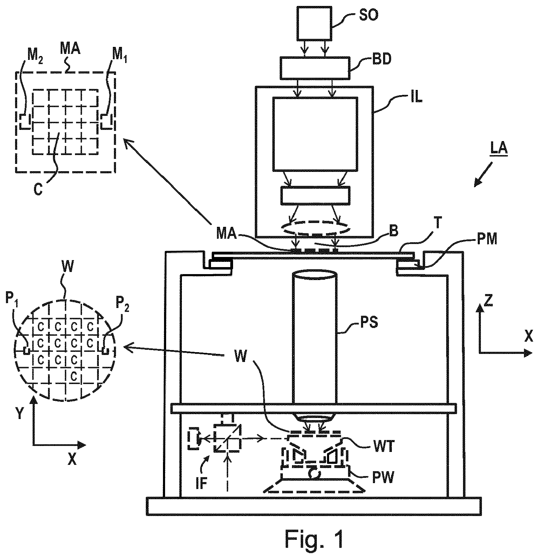

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support structure (e.g., a mask table) T constructed to support a patterning device (e.g., a mask) MA and connected to a first positioner PM configured to accurately position the patterning device MA in accordance with certain parameters, a substrate table (e.g., a wafer table) WT constructed to hold a substrate (e.g., a resist coated wafer) W and connected to a second positioner PW configured to accurately position the substrate in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illuminator IL receives a radiation beam from a radiation source SO, e.g. via a beam delivery system BD. The illumination system IL may include various types of optical components, such as refractive, reflective, magnetic, electromagnetic, electrostatic, or other types of optical components, or any combination thereof, for directing, shaping, or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system" PS.

The lithographic apparatus may be of a type wherein at least a portion of the substrate may be covered by a liquid having a relatively high refractive index, e.g., water, so as to fill a space between the projection system and the substrate - which is also referred to as immersion lithography. More information on immersion techniques is given in U. S. Patent No. 6,952,253 and in PCT publication No. WO99-49504, which are incorporated herein by reference.

The lithographic apparatus LA may also be of a type having two (dual stage) or more substrate tables WT and, for example, two or more support structure T (not shown). In such "multiple stage" machines the additional tables / structures may be used in parallel, or preparatory steps may be carried out on one or more tables while one or more other tables are being used for exposing the design layout of the patterning device MA onto the substrate W.

In operation, the radiation beam B is incident on the patterning device (e.g., mask MA), which is held on the support structure (e.g., mask table T), and is patterned by the patterning device MA. Having traversed the mask MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and possibly another position sensor (which is not explicitly depicted in Figure 1) may be used to accurately position the mask MA with respect to the path of the radiation beam B. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks).

Embodiments of the present invention provide novel marks made as binary gratings. A general framework of mark design insensitive to asymmetries is provided. A general framework of mark design insensitive to depth variation is also provided. Only one single wavelength is required with the novel mark design to mitigate the effects of process-induced mark asymmetry. Furthermore, alignment signal strength (Wafer Quality WQ) may be tunable simply by adjusting the marks' pitch. The marks simplify reference wafer manufacturing, providing "golden" reference wafers for wafer-to-wafer error correction, since they are insensitive to process-induced mark asymmetry.

Embodiments provide a novel of binary mark design that is insensitive to most type of asymmetries (FT, SWA) over a wide design-rule margin. It is insensitive to depth variation and therefore to process fluctuations for any asymmetry (FT, SWA, TT).

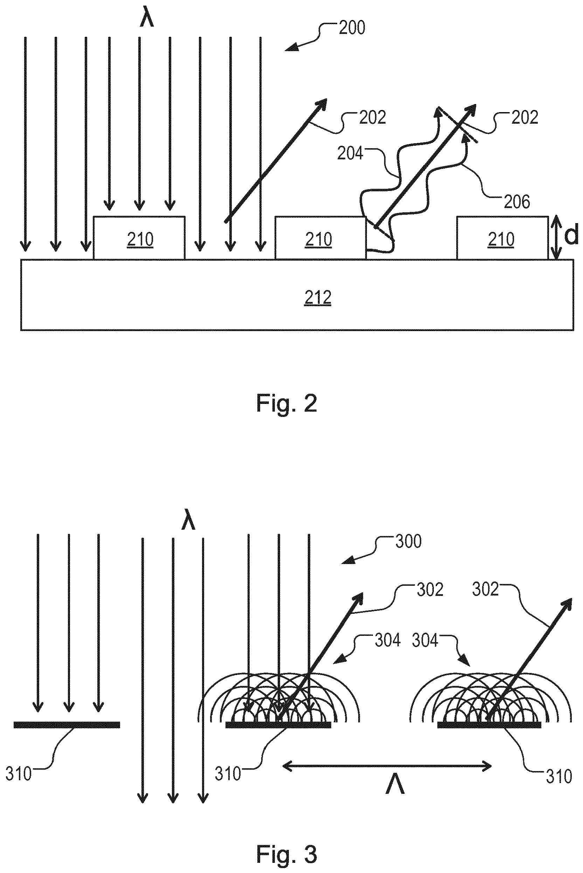

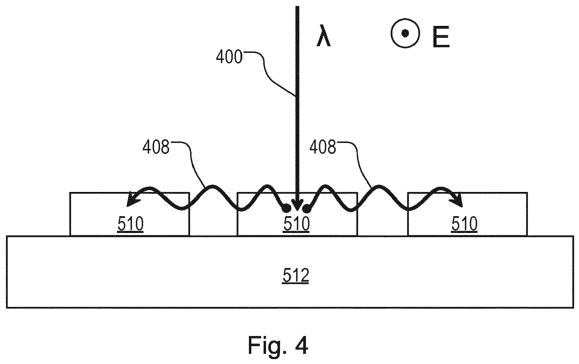

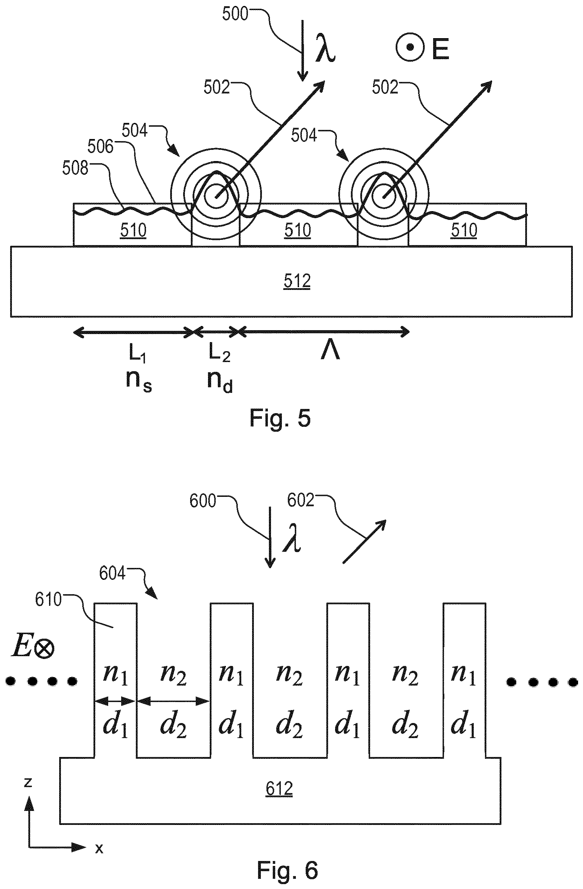

Before considering the novel mark, the conventional phase grating will be described (Figure 2) and the principle of amplitude gratings (Figure 3) and generation of resonance (Figure 4) will be described along with the mark disclosed in WO2019081091A1 (Figure 5).

Figure 2 depicts diffraction by a conventional phase grating. Radiation 200 of wavelength $\lambda$ illuminates the periodic structure 210 formed on a planar substrate 212 which in this example is a grating shown in cross-section. The gap between the ridges 210 forms a trench of depth d extending down to the substrate 212. This (d) is the mark depth. Interference between scattered radiation 204, 206 reflected at the top and at the bottom of the grating 210 respectively is constructive for an optimal thickness d to produce scattered radiation 202. Diffraction thus occurs via modulation of the phase of the reflected wave. The grating introduces a periodic modulation of the wavefront.

Figure 3 depicts diffraction by an amplitude grating. Radiation 300 of wavelength $\lambda$ illuminates the grating 310. Radiation 302 diffracted by a grating with periodic apertures in a reflective film depends only on the period $\Lambda$. The reflective film is equivalent to a set of point sources 304. In contrast to the phase grating, diffraction occurs via modulation of the amplitude of the reflected wave, rather than the phase. In common with the phase grating, the amplitude grating introduces a periodic modulation of the wavefront.

Figure 4 depicts a grating in the resonance regime. Radiation 400 of wavelength $\lambda$ illuminates the grating 510. The incoming radiation 400 resonantly excites to counter-propagating waves 408 in the grating plane. The grating itself introduces the momentum required.

Figure 5 depicts a resonant amplitude mark (RAM), in accordance with the disclosure of WO2019081091A1. A mark is formed on a planar substrate 512. The mark has a periodic structure configured to scatter radiation 502 of wavelength $\lambda$ incident 500 on a surface plane 506 of the alignment mark. The surface plane 506 is parallel to the substrate's plane. The scattering is mainly by excitation of a resonant mode 508 in the periodic structure parallel to the surface plane.

The periodic structure has a repeated unit cell divided into adjacent first 510 and second 504 portions along a direction of periodicity (left-to-right in the cross-section of Figure 5).

The first portion 510 has a first effective refractive index ($n_s$) and a first length ($L_1$) along the direction of periodicity. The second portion 504 has a second effective refractive index ($n_d$), which is lower over its optical path compared to the first effective refractive index, and a second length ($L_2$) along the direction of periodicity.

The effective refractive indexes ($n_s$, $n_d$) and lengths ($L_1$, $L_2$) of the portions are configured to provide an optical path length of the unit cell in the direction of periodicity ($n_sL_1 + n_dL_2$) that equals an integer multiple of a wavelength present in the spectrum of the radiation ($m\lambda$).

The wavelength of the incident radiation may be predetermined such that it matches the resonance design rules. Alternatively, broadband radiation may be incident on a marker and an alignment sensor frequency filter may be tuned afterwards to select the resonant mode wavelength.

The effective refractive indexes ($n_s$, $n_d$) and lengths ($L_1$, $L_2$) of the portions are also configured to provide an optical path length of the second portion in the direction of periodicity ($n_dL_2$) that is equal to half of an integer multiple of the wavelength present in the spectrum of the radiation ($k\lambda/2$). These are conditions matching the radiation wavelength to the grating material boundary conditions so as to support a resonance.

In this example, the optical path length of the second portion in the direction of periodicity ($n_dL_2$) is equal to half of the wavelength present in the spectrum of the radiation ($\lambda/2$), therefore there is only one antinode of the resonant mode in the second portion 504, i.e. k=1. When k>1, there are an odd number of antinodes, but an even number of antinodes cancel out, leaving just one antinode that contributes to the scattering, but with reduced efficiency.

The mark is formed on a planar substrate such as a wafer W, as depicted as $P_1$ and $P_2$ in Figure 1.

The radiation diffracted by the mark does not contain information regarding the mark outline, but only about the mark position on the wafer. The mark may be referred to as a Resonant Amplitude Mark (RAM). The terminology has been chosen to highlight the different working principle of such RAM with respect to traditional alignment marks based on phase grating (as described with reference to Figure 2). "Mark" and "grating" may be used interchangeably. The grating may be a 1-dimentisonal (1-D) grating, as described with reference to the example of Figure 5, but the invention is not limited to 1-D gratings. It may be applied to 2-D gratings with the effective refractive indices and lengths in both directions of periodicity configured to support a resonance.

In this mark design, radiation coming from the alignment sensor excites two counter-propagating waves in the grating plane. These two waves form a so called "standing wave", i.e. a resonant mode in the grating plane. As described with reference to Figure 4, these two counter-propagating waves do not propagate through the mark depth, but remain at the mark surface, and therefore are not influenced by the mark depth.

This resonant mode effectively leaks light into grating orders, as any other type of mark, and can be captured in the very same way as for conventional marks, and therefore no new sensor design is required. In fact, the sensor will not be able to discern if the light comes from a RAM or a conventional mark, with the advantage that light coming from a RAM doesn't contain information about the mark outline, but only about the mark position, since the resonant mode lies in the grating plane. Effectively, this mark behaves as an amplitude mark, in the sense that the light diffracted in the grating orders comes from point sources localized on the grating surface in a periodic fashion, whose radiation properties don't depend on the mark depth. This is similar to the scenario with periodic slits opened in a reflective opaque film, as described with reference to Figure 3.

With the appropriate design, this makes the mark much less sensitive to the presence of layer stacks below it, and it can be also be used as overlay target (see Figure 17 of WO2019081091A) or in mark stacking (see Figure 16 of WO2019081091A).

For configuration of the of the RAM, it is desirable to have efficient coupling to the resonant mode and efficient leaking of the mode in the sensor plane.

These are provided by using the following design rules:

The optical path of the grating unit cell equals an integer multiple of the wavelength:

$$n_S L_1 + n_d L_2 = m\lambda \tag{1}$$

and the optical path of the low index material (space) equals half the wavelength:

$$n_d L_2 = k\lambda/2, \tag{2}$$

where $L_1 + L_2 = \Lambda$ (pitch) and $k$ is an integer, preferably $k=1$. From these two simple design rules, different pitches can be used for a specific color, accordingly with the sensor specification (numerical aperture, NA). Therefore, for a fixed wavelength $\lambda$, an increase in the mark pitch $\Lambda$ would result in a larger duty cycle.

In embodiments of the present invention, the diffraction similarly mainly happens at the grating top interface with very little light diffracted from the grating bottom interface. Figure 6 depicts a guided mode mark (GMM) as a 1-dimensional photonic crystal for defining the nominal design rule.

With reference to Figure 6, the k vector in air along the x direction is

$$k_2 = n_2 \frac{\omega}{c}.$$

The k vector in silicon along the x direction is

$$k_1 = n_1 \frac{\omega}{c}.$$

The period of the ID photonic crystal is

$$d = d_1 + d_2.$$

The dispersion relation of 1D photonic crystal is

$$k_x(\omega) \cdot d = \arccos\{\frac{1}{2} \cdot [2\cos k_1 d_1 \cos k_2 d_2 - (\frac{k_2}{k_1} + \frac{k_1}{k_2})\sin k_1 d_1 \sin k_2 d_2]\}.$$

Solving for the eigen mode with kx=0 and $d_2 = \frac{\lambda}{2n_2}$ we get the nominal design rule:

$$d_2 = \frac{\lambda}{2n_2} \qquad\qquad (3)$$

$$d_1 = \frac{2m-1}{2n_1}\lambda; m = 1,2,3\cdots. \qquad\qquad (4)$$

Next we change the nomenclature to match that of equations (1) and (2).

In the portion that has a lower effective refractive index (e.g. air):

$d_2$ becomes $L_2$ and $n_2$ becomes $n_d$.

In the portion that has a higher effective refractive index (e.g. Si):

$d_1$ becomes $L_1$ and $n_1$ becomes $n_s$.

Therefore, equating $\lambda$ with $\lambda$ (in italics) and m with m (in italics),

$$d_2 = \frac{\lambda}{2n_2} \text{ and } d_1 = \frac{2m-1}{2n_1}\lambda; m = 1,2,3\cdots$$

becomes

$$L_2 = \frac{\lambda}{2n_d} \text{ and } L_1 = \frac{2m-1}{2n_s}\lambda; m = 1,2,3\cdots$$

Therefore,

$$n_d L_2 = \frac{\lambda}{2}$$

This is the same design rule as equation (2).

Furthermore,

$$n_s L_1 = (2m-1)\frac{\lambda}{2}; m = 1,2,3\cdots$$

Adding $n_d L_2 = \frac{\lambda}{2}$ to both sides:

$$n_s L_1 + n_d L_2 = (2m-1)\frac{\lambda}{2} + \frac{\lambda}{2}; m = 1,2,3\cdots$$

$$n_s L_1 + n_d L_2 = (2m-1+1)\frac{\lambda}{2}; m = 1,2,3\cdots$$

$$n_s L_1 + n_d L_2 = m\lambda; m = 1,2,3\cdots$$

This is the same design rule as equation (1). Therefore, the waveguide theory framework leads to the same nominal design rule (equations (3) and (4)) as the resonant mode approach disclosed in WO2019081091A1 (equations (1) and (2)). However, using waveguide theory it has revealed that design rules for such marks are no longer restricted to the nominal design rules based on resonance.

Figure 6 depicts a guided mode mark (GMM), in accordance with the embodiments of the present invention.

A mark is formed on a planar substrate 612. The mark has a periodic structure configured to scatter radiation 602 of wavelength $\lambda$ incident 600 on the alignment mark. The scattering is mainly by coupling of the incident radiation to a waveguiding mode in the periodic structure.

The periodic structure has a repeated unit cell divided into adjacent first 610 and second 604 portions along a direction of periodicity (the x-direction; left-to-right in the cross-section of Figure 6).

The first portion 610 has a first effective refractive index ($n_1$) and a first length ($d_1$) along the direction of periodicity. The second portion 604 has a second effective refractive index ($n_2$), which is lower over its optical path compared to the first effective refractive index, and a second length ($d_2$) along the direction of periodicity.

The effective refractive indexes ($n_1$, $n_2$) and lengths ($d_1$, $d_2$) of the portions are configured to provide an optical path length of the unit cell in the direction of periodicity ($n_1d_1 + n_1d_1$) that equals an integer multiple of a wavelength present in the spectrum of the radiation ($m\lambda$).

The wavelength of the incident radiation may be predetermined such that it matches the waveguide theory design rules. Alternatively, broadband radiation may be incident on a marker and an alignment sensor frequency filter may be tuned afterwards to select a wavelength associated with a desired waveguiding mode.

The effective refractive indexes ($n_1$, $n_2$) and lengths ($d_1$, $d_2$) of the portions are also configured to provide an optical path length of the second portion in the direction of periodicity ($n_2d_2$) that is preferably equal to from 0.30 to 0.49 (more preferably from 0.35 to 0.45) of the wavelength present in the spectrum of the radiation. These are conditions matching the radiation wavelength to the grating material boundary conditions so as to support generation of a waveguiding mode

The mark is formed on a planar substrate such as a wafer W, as depicted as $P_1$ and $P_2$ in Figure 1.

The radiation diffracted by the mark does not contain information regarding the mark outline, but only about the mark position on the wafer. The mark may be referred to as a Guided Mode Mark (GMM). The terminology has been chosen to highlight the different working principle of such GMM with respect to traditional alignment marks based on phase grating (as described with reference to Figure 2) and the RAM described with reference to Figure 5. "Mark" and "grating" may be used interchangeably. The grating may be a 1-dimentisonal (1-D) grating, as described with reference to the example of Figure 6, but the invention is not limited to 1-D gratings. It may be applied to 2-D gratings with the effective refractive indices and lengths in both directions of periodicity configured to support a resonance.

With the appropriate design, this makes the mark much less sensitive to the presence of layer stacks below it, and it can be also be used as overlay target (see Figure 17 of WO2019081091A) or in mark stacking (see Figure 16 of WO2019081091A).

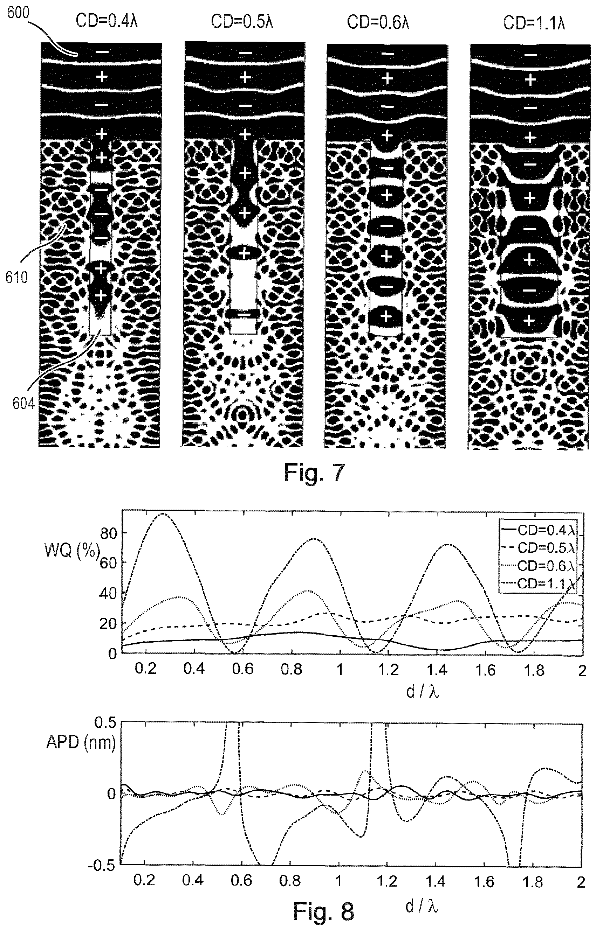

Once the nominal design rules are met, the light will be mainly coupled to the waveguiding mode mainly confined and propagated inside the silicon ridges and coupling evanescently with its neighboring silicon ridge through the trench (see the field distribution in Figure 7 for CD = 0.5*$\lambda$, where CD is the width of the air trench). As a result, FT will have the least impact on the APD. The SWA slightly affect the guided mode, only for unrealistic large mark depth. The TT is on the grating top interface which will affect the coupling of light into the waveguiding modes, manifests mainly as a general offset. Since in all the three type of asymmetries, the diffraction mainly happens at the grating top interface, the APD results by asymmetries are less dependent on mark depths comparing to traditional mark types.

However, surprisingly, using the waveguide theory framework, for the CD = 0.4*$\lambda$ case, we also observe a small APD in the simulations. We can see from the field distribution that the light can still be coupled to the waveguide mode but not as well as CD = 0.5*$\lambda$. It indicates that the design rules disclosed in WO2019081091A1 and represented by equations (1) to (4) do not need to be met exactly. In this case, a very small portion of light is propagating in the trench but with a small effective mode index. The geometrical asymmetries will introduce less phase asymmetries due to the small effective mode index. The small effective mode index effect leads to the small APDs.

Another effect which also contributes to the small APD for FT is the small CD effect. In this mark type the duty cycle (space:line) is less than 50%. As a result, same degree of mark asymmetries will induce smaller shifts in center of gravity of the mark. This effect applies to both s- and p-polarization.

Figure 7 depicts field distributions for a single trench for each of four different critical dimensions (CD), where CD is the width of the air trench. "-" represents a negative value of the electric field. "+" represents a positive value of the electric field. Either side of and below the trench, the black patterns represent alternating negative and positive electric field values in the silicon.

Figure 8 depicts Wafer Quality (WQ) and Alignment Position Deviation (APD) as a function of alignment mark depth, d, (from 0.2$\lambda$ ~2$\lambda$) in the presence of 1nm Floor Tilt asymmetry for each of the four different critical dimensions shown in Figure 7. WQ is the alignment signal strength.

The following table of results can be obtained from Figure 8.

| s-pol (0.2λ ~2λ) | cd=0.4λ | cd=0.5λ | cd=0.6λ | cd=1.1λ | STD |
|---|---|---|---|---|---|
| WQ | 2.96~14.17 [Δ 11.21] | 15~27.3 [Δ 12.3] | 4.7~41.5 [Δ 36.8] | 0~92.5[Δ 92.5] | 0~90 [Δ 90] |
| APD [nm] | -0.037~0.061 [Δ 0.098] | -0.041~0.042 [Δ 0.082] | -0.154~0.165 [Δ 28] | -0.84~7.3 [Δ 8.14] | -19~16 [Δ 35] |

This table shows that the mark is insensitive to mark depth over a wide margin of CD because (for a mark depth range of 0.2 lambda to 2 lambda) it leads to a small simulated APD variation for both cd = 0.5λ and cd = 0.4λ, in the case of a typical FT value of 1 nm.

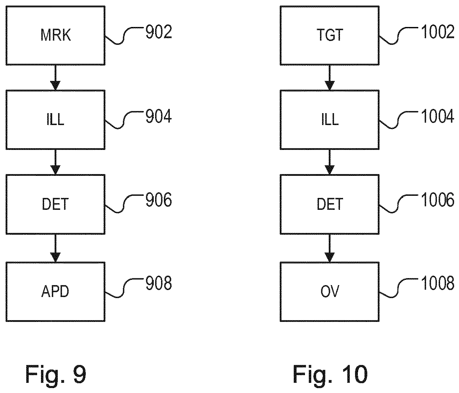

Figure 9 is a flowchart of a method of alignment in accordance with an embodiment of the present invention. The method of alignment has the following steps.

902 (MRK): Providing an alignment mark formed on a planar substrate.
904 (ILL): Illuminating the alignment mark with radiation of the predetermined wavelength.
906 (DET): Detecting the radiation scattered by the alignment mark arising from the illumination.
908 (APD): Determining a position of the alignment mark (APD) using the detected radiation.

The alignment mark has a periodic structure configured to scatter radiation incident on the alignment mark. The scattering is mainly by coupling of the incident radiation to a waveguiding mode in the periodic structure.

Figure 10 is a flowchart of a method of overlay error measurement in accordance with an embodiment of the present invention. The method of determining an overlay error has the following steps.

1002 (TGT): Providing an overlay target formed on a planar substrate. The overlay target has a lower mark overlaid with an upper mark having a pitch the same as the lower mark. The lower mark has a periodic structure configured to scatter radiation incident on a surface plane of the lower mark. The surface plane is parallel to the substrate's plane. The scattering is mainly by coupling of the incident radiation to a waveguiding mode. The upper mark has a periodic structure configured to scatter radiation of the predetermined wavelength without scattering mainly by coupling of the incident radiation to a waveguiding mode in its periodic structure.
1004 (ILL): Illuminating the overlay target with radiation of the predetermined wavelength.
1006 (DET): Detecting the radiation scattered by the overlay target arising from the illumination.
1008 (OV): Determining an overlay error OV between the upper and lower marks using the detected radiation.

With reference to Figures 9 and 10, the periodic structure has a repeated unit cell divided into adjacent first and second portions along a direction of periodicity. The first portion has a first effective refractive index and a first length along the direction of periodicity. The second portion having a second effective refractive index, which is lower over its optical path compared to the first effective refractive index, and a second length along the direction of periodicity. The effective refractive indexes and lengths of the portions are configured to provide an optical path length of the unit cell in the direction of periodicity that equals an integer multiple of a wavelength present in the spectrum of the radiation. The effective refractive indexes and lengths of the portions are configured to provide an optical path length of the second portion in the direction of periodicity that is preferably equal to from 0.30 to 0.49 (more preferably from 0.35 to 0.45) of the wavelength present in the spectrum of the radiation.

Embodiments of the present invention have several advantages over a wider design rule margin compared to the disclosure of WO2019081091A1.

The alignment and overlay measurement methods are are less complex; only one single wavelength is needed for alignment purposes, since WQ and APD do not vary as a function of the mark depth, for GMM, over a wider margin.

The alignment and overlay measurement methods are more accurate; in the case of process-induced asymmetry, especially for FT, the APD obtained for GMM is extremely small; for a typical value of FT=1 nm, the APD is smaller than 0.5 Angstrom, over a wider margin.

The alignment and overlay measurement methods are faster, especially in the case of tunable light sources that can provide only one color at a time, over a wider margin.

The marks and targets may be used in golden reference wafers for wafer-to-wafer error correction, since they are insensitive to asymmetry, over a wider margin.

There is an improvement in Copper Dual Damascene type structures; the presence of layers below the GMM mark has a limited impact on the signal, therefore allowing a more robust APD or OV readout, over a wider margin.

Similar to as described with reference to Figure 17 of WO2019081091A1, GMM can be used as the bottom grating of the overlay target, to reduce the effect of layers underneath the mark that affect the overlay readout signal, over a wider margin.

Furthermore, embodiments of the present invention are compatible with smaller marks, over a wider margin.

Embodiments provide sub-angstrom APD for FT=1nm

Embodiments provide sub-nanometer APD for SWA=1 degree for a realistic mark depth range[0.1-1 lambda]

Embodiments are insensitive to mark depth, (for example having APD variation of -0.08 nm for FT and -0.4 nm for SWA), so facilitate higher etching/polishing/deposition tolerances of lithographic processing tools.

Although specific reference may be made in this text to the use of lithographic apparatus in the manufacture of ICs, it should be understood that the lithographic apparatus described herein may have other applications, such as the processing of substrates in the manufacture of integrated optical systems, guidance and detection patterns for magnetic domain memories, flat-panel displays, liquid-crystal displays (LCDs), thin film magnetic heads, etc. The skilled artisan will appreciate that, in the context of such alternative applications, any use of the terms "wafer" or "field"/"die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multilayer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below. In addition, it should be appreciated that structural features or method steps shown or described in any one embodiment herein can be used in other embodiments as well.

**Claims**

1. A mark formed on a planar substrate, the mark comprising a periodic structure configured to scatter radiation incident on the alignment mark, the scattering mainly by coupling of the incident radiation to a waveguiding mode in the periodic structure, wherein the periodic structure has a repeated unit cell divided into adjacent first and second portions along a direction of periodicity,

   - the first portion having a first effective refractive index and a first length along the direction of periodicity,
   - the second portion having a second effective refractive index, which is lower over its optical path compared to the first effective refractive index, and a second length along the direction of periodicity,

   wherein the effective refractive indexes and lengths of the portions are configured to provide:

   - an optical path length of the unit cell in the direction of periodicity that equals an integer multiple of a wavelength present in the spectrum of the radiation and
   - an optical path length of the second portion in the direction of periodicity that is from 0.30 to 0.49 of the wavelength present in the spectrum of the radiation.

2. The mark of claim 1, wherein the effective refractive indexes and lengths of the portions are configured to provide the optical path length of the second portion in the direction of periodicity that is from 0.35 to 0.45 of the wavelength present in the spectrum of the radiation.

3. A substrate comprising the mark of claim 1 or claim 2.

4. An overlay target comprising a lower mark in accordance with claim 1 or claim 2, overlaid with an upper mark having a pitch the same as the lower mark and comprising a periodic structure configured to scatter radiation without scattering mainly by coupling of the incident radiation to a waveguiding mode in its periodic structure.

5. A substrate comprising the overlay target of claim 4.

6. A method of alignment comprising the steps:

   - providing an alignment mark formed on a planar substrate, in accordance with the mark of claim 1 or claim 2;
   - illuminating the alignment mark with radiation;
   - detecting the radiation scattered by the alignment mark arising from the illumination; and
   - determining a position of the alignment mark using the detected radiation.

7. A method of determining an overlay error comprising the steps:

   - providing an overlay target formed on a planar substrate, the overlay target comprising a lower mark overlaid with an upper mark having a pitch the same as the lower mark, wherein:

      - the lower mark comprises a mark in accordance with claim 1 or claim 2; and
      - the upper mark comprises a periodic structure configured to scatter radiation without scattering mainly by coupling of the incident radiation to a waveguiding mode in its periodic structure;

   - illuminating the overlay target with radiation;
   - detecting radiation scattered by the overlay target arising from the illumination; and
   - determining an overlay error between the upper and lower marks using the detected radiation.

Fig. 1

λ

200

202

204

202

206

210   210   210   d

212

Fig. 2

λ

300

302   302

304  304

310

310   Λ   310

Fig. 3

Fig. 4

Fig. 5

Fig. 6

Fig. 7

Fig. 8

```
┌─────────┐              ┌─────────┐
│   MRK   │──╮902        │   TGT   │──╮1002
└─────────┘              └─────────┘
     │                        │
     ▼                        ▼
┌─────────┐              ┌─────────┐
│   ILL   │──╮904        │   ILL   │──╮1004
└─────────┘              └─────────┘
     │                        │
     ▼                        ▼
┌─────────┐              ┌─────────┐
│   DET   │──╮906        │   DET   │──╮1006
└─────────┘              └─────────┘
     │                        │
     ▼                        ▼
┌─────────┐              ┌─────────┐
│   APD   │──╮908        │   OV    │──╮1008
└─────────┘              └─────────┘
```

Fig. 9                  Fig. 10

Europäisches
Patentamt

European
Patent Office

Office européen
des brevets

# EUROPEAN SEARCH REPORT

Application Number

EP 19 18 6925

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | WO 2019/081091 A1 (ASML NETHERLANDS BV [NL]) 2 May 2019 (2019-05-02) * paragraphs [0032] - [0045]; figure 5 * * paragraph [0054] * * paragraphs [0064] - [0067]; figure 17 * * claim 3 * | 1-7 | INV. G03F9/00 G03F7/20 |
| X | US 2009/310113 A1 (MUSA SAMI [NL] ET AL) 17 December 2009 (2009-12-17) * paragraphs [0060] - [0067], [0084] - [0089]; figure 3 * | 1-3,6 | |
| X | EP 1 788 451 A1 (ASML NETHERLANDS BV [NL]) 23 May 2007 (2007-05-23) * paragraphs [0039] - [0041]; figure 2 * | 1-3,6 | |
| X | EP 1 628 164 A2 (ASML NETHERLANDS BV [NL]) 22 February 2006 (2006-02-22) * paragraphs [0027] - [0031]; figures 4a, 4b * | 4,5,7 | |

TECHNICAL FIELDS
SEARCHED       (IPC)

G03F

The present search report has been drawn up for all claims

| Place of search | Date of completion of the search | Examiner |
|---|---|---|
| Munich | 29 January 2020 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 18 6925

This annex lists the patent family members relating to the patent documents cited in the above-mentioned European search report.
The members are as contained in the European Patent Office EDP file on
The European Patent Office is in no way liable for these particulars which are merely given for the purpose of information.

29-01-2020

| Patent document cited in search report | | | Publication date | Patent family member(s) | | | Publication date |
|---|---|---|---|---|---|---|---|
| WO 2019081091 | A1 | | 02-05-2019 | TW | 201923491 | A | 16-06-2019 |
| | | | | WO | 2019081091 | A1 | 02-05-2019 |
| US 2009310113 | A1 | | 17-12-2009 | JP | 4797087 | B2 | 19-10-2011 |
| | | | | JP | 2009302534 | A | 24-12-2009 |
| | | | | US | 2009310113 | A1 | 17-12-2009 |
| EP 1788451 | A1 | | 23-05-2007 | CN | 1983036 | A | 20-06-2007 |
| | | | | EP | 1788451 | A1 | 23-05-2007 |
| | | | | JP | 4454614 | B2 | 21-04-2010 |
| | | | | JP | 2007142419 | A | 07-06-2007 |
| | | | | KR | 20070054123 | A | 28-05-2007 |
| | | | | SG | 132640 | A1 | 28-06-2007 |
| | | | | TW | I411895 | B | 11-10-2013 |
| | | | | US | 2007114678 | A1 | 24-05-2007 |
| EP 1628164 | A2 | | 22-02-2006 | CN | 1916603 | A | 21-02-2007 |
| | | | | EP | 1628164 | A2 | 22-02-2006 |
| | | | | EP | 2239632 | A1 | 13-10-2010 |
| | | | | JP | 4357464 | B2 | 04-11-2009 |
| | | | | JP | 4898869 | B2 | 21-03-2012 |
| | | | | JP | 2006060214 | A | 02-03-2006 |
| | | | | JP | 2009204621 | A | 10-09-2009 |
| | | | | KR | 20060050488 | A | 19-05-2006 |
| | | | | SG | 120263 | A1 | 28-03-2006 |
| | | | | SG | 139763 | A1 | 29-02-2008 |
| | | | | SG | 173420 | A1 | 29-08-2011 |
| | | | | SG | 10201500569R | A | 30-03-2015 |
| | | | | TW | I294518 | B | 11-03-2008 |
| | | | | US | 2006033921 | A1 | 16-02-2006 |
| | | | | US | 2006066855 | A1 | 30-03-2006 |
| | | | | US | 2011007314 | A1 | 13-01-2011 |
| | | | | US | 2012038929 | A1 | 16-02-2012 |
| | | | | US | 2014055788 | A1 | 27-02-2014 |
| | | | | US | 2014233025 | A1 | 21-08-2014 |
| | | | | US | 2019170657 | A1 | 06-06-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019081091 A1
- US 6952253 B
- WO 9949504 A
- WO 2019081091 A